# EUROPÄISCHE PATENTSCHRIFT

(11) **EP 1 653 621 B1**
(45) Veröffentlichungstag und Bekanntmachung des Hinweises auf die Patenterteilung: **23.12.2009**
(21) Anmeldenummer: 05021757.9
(22) Anmeldetag: 06.10.2005
(51) Int. Cl.: H03K 17/96

(54) **Optischer Berührschalter**
Optical touch switch
Commutateur optique à touche tactile

(30) Priorität: 28.10.2004 DE 102004053496
(43) Veröffentlichungstag der Anmeldung: 03.05.2006
(73) Patentinhaber: E.G.O. ELEKTRO-GERÄTEBAU GmbH, 75038 Oberderdingen (DE)
(72) Erfinder: Baier, Martin, 76275 Ettlingen (DE)
(74) Vertreter: Patentanwälte Ruff, Wilhelm, Beier, Dauster & Partner

(56) Entgegenhaltungen:
- WO-A-84/03186
- DE-A1- 2 936 815
- US-A- 3 621 268
- US-A- 4 051 365

## Beschreibung

Die Erfindung betrifft einen optischen Berührschalter, insbesondere für ein zumindest teilweise lichtdurchlässiges Glaskeramikkochfeld, mit wenigstens einem Lichtsender und wenigstens einem Lichtempfänger an oder in wenigstens je einem oder einem gemeinsamen Träger.

Eine derartige Vorrichtung ist aus EP 0 766 887 B1 bekannt. Darin wird ein selbstleuchtender optischer Berührschalter mit einer Lichtquelle beschrieben, deren abgestrahltes Licht mit einem Linsensystem kollimiert und anschließend auf wenigstens einen Brennpunkt gebündelt werden. Im Brennpunkt trifft das Licht auf eine transparente Oberfläche. Wird die transparent Oberfläche auf der Seite abgedeckt, die der Lichtquelle abgewandt ist, wird das Licht in Richtung des Linsensystems zurückreflektiert. Dieses verändert den Strahlengang des reflektierten Lichts so, dass das Licht auf einen Detektor geleitet wird, der einfallendes Licht und dessen Intensität feststellt und ein entsprechendes Signal erzeugt. Nachteilig zeigt sich bei dieser Anordnung der aufwändige und kostspielige Aufbau, der sich aus dem Linsensystem und dessen notwendiger exakter Montage ergibt.

Aus der EP 446 642 ist ersichtlich, wie jeweils durch Ausrichtung von Lichtsender und Lichtempfänger bei Reflex-Lichtschranken eine verbesserte Berührschalteranordnung geschaffen werden kann. Hier werden Lichtsender und Lichtempfänger derart schräg ausgerichtet, dass der ausgesandte Mittelstrahl des Lichtsenders von einem die Berührung auslösenden Finger genau in den Lichtempfänger reflektiert wird.

Aus der DE-U 200 08 425 ist es bekannt, bei Berührschalteranordnungen eine Matte mit Ausschnitten über eine Leiterplatte mit aufgesetzten Reflex-Lichtschranken zu legen. Diese Matte weist Ausnehmungen auf, die jeweils genau an der Stelle eines Lichtsenders und eines Lichtempfängers angeordnet sind. Mit der Matte kann zum einen das Einhalten eines Abstands zur Unterseite eines Glaskeramikkochfeldes erreicht werden. Des weiteren kann so eine Begrenzung sowohl der vom Lichtsender ausgestrahlten Lichtstrahlen als auch der vom Lichtempfänger empfangenen Lichtstrahlen erfolgen.

Die DE 2936815 A1 beschreibt eine Schalttafel mit Berührungsschaltern, die unter einer Glasplatte angeordnet sind. Der Berührungsschalter weist einen Lichtsender und einen Lichtempfänger auf und arbeitet nach dem Prinzip einer Reflexionslichtschranke. Lichtsender und Lichtempfänger können dabei jeweils in voneinander getrennten Schutzröhrchen angeordnet sein.

### Aufgabe und Lösung

Aufgabe der Erfindung ist es daher, einen Berührschalter der eingangs genannten Art zu schaffen, der die Nachteile des Standes der Technik behebt und der insbesondere eine Vereinfachung seines Aufbaus ermöglicht.

Gelöst wird die Aufgabe durch einen Berührschalter mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Erfindungsgemäß ist das von dem Lichtsender ausgehende Lichtsignal und/oder das von dem Lichtempfänger zu empfangende Lichtsignal durch wenigstens einen maskenartigen Abschnitt des Trägers mit wenigstens einer Ausnehmung und/oder einem Trennsteg begrenzt. Der Träger kann dabei ein weitestgehend flächiger Körper mit einer geringen Höhenausdehnung sein, in dem die wenigstens eine Ausnehmung angeordnet ist, beispielsweise einen Träger für elektrische und/oder elektronische Bauteile wie eine Leiterplatte oder dergleichen. Die wenigstens eine Ausnehmung kann zumindest teilweise parallele Flanken aufweisen, durch die das vom Lichtsender ausgehende Lichtsignal seitlich begrenzt wird. Ebenfalls durch die wenigstens eine oder eine weitere Ausnehmung wird der Empfangsbereich des Lichtempfängers begrenzt, der so annähernd auf einen Punkt, zumindest jedoch auf eine bestimmte Fläche einschränkbar ist. Bei einer entsprechenden Wahl der Dimensionen und der Form der Ausnehmung wird das Licht durch die Ausnehmung begrenzt, dessen einzelne Lichtstrahlen in etwa zur Hauptsenderichtung des Lichtsenders ausgerichtet sein können. Vorzugsweise weisen die Ausnehmungen eine lichte Weite von bis zu 10mm, vorzugsweise eine lichte Weite von 1 mm bis 3mm auf.

Ein Schaltvorgang des Berührschalters wird dadurch ausgelöst, dass Licht von dem Lichtsender in den Empfangsbereich des Lichtempfängers eintritt. Dabei spielt es keine Rolle, ob der Lichtsender und der Lichtempfänger an einem oder mehreren Trägern angeordnet sind, wobei eine Anordnung an einem Träger einfacher ist.

Um einen ungewollten Schaltvorgang zu vermeiden, der beispielsweise durch vom Lichtsender ausgehendes und auf den Lichtempfänger treffendes Streulicht ausgelöst wird, können für den Lichtsender und den Lichtempfänger je eine separate Ausnehmung im gemeinsamen Träger vorgesehen sein. Bei der Anordnung von Lichtsender und Lichtempfänger an einem Träger mit nur einer Ausnehmung im Träger kann zur Vermeidung von Streulicht zwischen dem Sender und dem Empfänger eine Trennvorrichtung, vorzugsweise ein Trennsteg oder eine Trennwand, vorgesehen sein. Ist diese zwischen Lichtsender und Lichtempfänge angeordnet, ist es vorteilhaft, wenn ihre Dimensionen die Höhenausdehnungen wenigstens des Senders oder des Empfängers überragen, insbesondere auch in Richtung weg von der Abdeckung. Eine kleinere Dimensionierung ist ausreichend, wenn der Trennsteg nur zwischen Strahlengang und Empfangsbereich vorgesehen ist. Auf eine weitere Optik oder Strahlengangsbegrenzung, die in den Strahlengang des Lichtsenders oder Lichtempfängers eingebracht oder diesem vorgelagert ist, kann also verzichtet werden.

In einer Ausgestaltung der Erfindung ist der Berührschalter als Reflexionslichtschranke mit einem Lichtsender, vorzugsweise einer lichtemittierenden Diode, kurz LED, und einem Lichtempfänger, vorzugsweise Phototransistor, einer pin-Diode oder einem lichtsensitiven Widerstand, ausgebildet. Die Hauptabstrahlrichtung des Lichtsenders, beziehungsweise die Hauptempfangsrichtung des Lichtempfängers ist auf den jeweiligen, dem Berührschalter zugeordneten, maskenartigen Abschnitt des Trägers weisend ausgerichtet. Die Lichtsignale treffen auf eine Berühroberfläche, an der die Signale zumindest teilweise in die Richtung des Lichtempfängers reflektiert werden. Dieser reagiert auf das Licht und initiiert ein Schaltsignal. Bei der Verwendung des Berührlichtschalters an einem Glaskeramikkochfeld ist der Berührschalter an der Unterseite des Kochfeldes bzw. darunter angeordnet. Der Träger von Lichtsender und Lichtempfänger ist derart ausgerichtet, dass ihre Hauptsende- und Hauptempfangsrichtungen durch das Kochfeld hindurch weisen. Das vom Lichtsender ausgesandte Licht kann dann in einem Grundzustand zumindest zu einem großen Teil durch das Kochfeld hindurch austreten. Wird zu der Stelle des Kochfeldes, an der das Licht wieder aus dem Kochfeld austritt, ein Gegenstand geführt, wird der Lichtstrahl an der vom Gegenstand bedeckten Kochfeldoberfläche zum Empfänger reflektiert. Der Gegenstand.kann beispielsweise ein Finger einer Bedienperson sein.

Durch die Ausrichtung der Hauptabstrahlrichtung des Lichtsenders und der Hauptempfangsrichtung des Lichtempfängers auf den jeweiligen, dem Berührschalter zugeordneten, maskenartigen Abschnitt des Trägers kann der Träger als Ersatz für eine zusätzliche Optik, beispielsweise eine Lichtstrahlabschirmung wie bei bisherigen Berührschaltern, dienen. Lichtsender und Lichtempfänger können so ausgerichtet werden, dass die Vektoren ihrer Hauptabstrahl- und Hauptempfangsrichtungen an der Kochfeldoberfläche nur einen geringen Abstand voneinander aufweisen oder sich vorzugsweise schneiden. Die Öffnungswinkel des Hauptabstrahlbereichs und des Hauptempfangsbereichs sind vorteilhaft in etwa gleich. Üblicherweise ist der Lichtstrahl ein ungerichteter Lichtstrahl.

Bei der Erfindung ist der Träger als Bauteilträger, insbesondere als Leiterplatte, ausgebildet und weist eine Bestückungsseite zur Aufnahme von Bauteilen auf. Ein solcher Träger kann neben den Bauteilen für den Berührschalter auch noch weitere Bauteile aufnehmen, die beispielsweise der Steuerung eines Glaskeramikkochfeldes dienen.

Durch die einseitige Bestückung der Leiterplatte weist die Leiterplatte eine weitestgehend ebene obere Seite auf. Mit dieser kann sie an Flächen, die vorzugsweise elektrisch isolierend ausgebildet sind, angelegt werden, ohne dass Schutzeinrichtungen für die an der Leiterplatte befestigten elektronischen Bauteile vorgesehen werden müssen. Eine Fläche kann die Unterseite einer Abdeckung wie ein Glaskeramikkochfeld sein, an der die Oberseite der Leiterplatte anliegen kann.

Bei der Erfindung liegt der Träger zumindest teilweise mit einer Seite an einer Unterseite einer Abdeckung an. Dabei ist die anliegende Seite des Trägers die Seite, die der Bestückungsseite gegenüberliegt. An der Bestückungsseite sind der Lichtsender und der Lichtempfänger vorgesehen. Da hier die aus dem Stand der Technik bekannten Lichtstrahlabschirmungen entfallen können, ergibt sich eine sehr kompakte Bauform des Berührschalters, dessen Höhle sich nur aus der Höhe der Leiterplatte und der Höhe der Bauteile auf der Leiterplatte zusammensetzt.

In einer Ausgestaltung der Erfindung sind Lichtsender und/oder Lichtempfänger teilweise in, vorzugsweise zumindest direkt an der wenigstens einen Ausnehmung im Träger befestigt. Durch die Positionierung von Lichtsender und Lichtempfänger an den Ausnehmungen können die Ausnehmungen als Ersatz für beispielsweise ein zusätzliches Röhrchen zur seitlichen Begrenzung des Strahlengangs verwendet werden.

In einer Ausgestaltung der Erfindung sind die Flanken der Ausnehmung gen im Träger beschichtet oder reflektierend ausgebildet. Dies kann vorteilhaft auch bei der Herstellung der Leiterplatte vorgenommen werden. Vorzugsweise ist dies mit einer reflektierenden Schicht realisiert, die insbesondere Kupfer oder noch besser Zinn aufweist. Die Schicht kann auch als Hülse gestaltet sein, die in die Ausnehmung eingebracht werden kann, vorzugsweise eingepresst. Durch die reflektierende Schicht in den Ausnehmungen wird nicht das gesamte Streulicht vom Träger abgeschirmt, sondern trifft auch noch auf den Lichtempfänger. So wird die Intensität des Strahls erhöht. An den Flanken der Ausnehmung des Lichtempfängers dient die reflektierende Schicht zum Sammeln von einfallenden Lichtstrahlen, so dass auch solche Strahlen zum Lichtempfänger geleitet werden, die nicht im exakten Winkel von der Oberfläche des Kochfeldes reflektiert werden.

In einer Ausgestaltung der Erfindung weist der Träger eine Dicke bis zu 5mm auf, die vorzugsweise zwischen 1,0mm und 2,0mm liegt. Dadurch kann der Lichtstrahl und der vom Lichtempfänger überwachbare Bereich bei entsprechender Größe der Ausnehmung mit 1 mm bis 5mm auf eine optimale Größe gebracht werden.

In einer Ausgestaltung der Erfindung ist die maskenartige Ausnehmung im Träger, vorzugsweise der Teil der Ausnehmung über dem Lichtsender, als eine Anzeigevorrichtung, vorzugsweise als Symbol, ausgebildet. Durch die entsprechend ausgeformte Öffnung im Träger kann der Lichtsender zu einer weiteren Funktion als Hinterleuchtung einer Anzeigevorrichtung genutzt werden. Die Anzeigevorrichtung kann unterschiedlich ausgebildet sein, so dass ein Piktogramm einer zu bedienenden Vorrichtung eines Elektrogerätes, beispielsweise eines Strahlungsheizkörpers eines Glaskeramikkochfeldes, abgebildet werden kann. Des weiteren sind beispielsweise eine Zahl, ein Buchstabe, ein Wort oder Kombinationen daraus möglich. Dabei spielt es jedoch keine Rolle, ob das Symbol als Ausnehmung dargestellt ist, durch den das Lichtbündel geführt ist, oder als Maske bzw. Fläche, die im Strahlengang einen Bereich abschattet.

In einer Ausgestaltung der Erfindung ist eine Anzeigevorrichtung als Mehrsegmentanzeige an dem Träger vorgesehen, insbesondere als Siebensegmentanzeige, ausgebildet, die zumindest teilweise von der Bestückungsseite des Trägers kommend in eine Ausnehmung im Träger ragt, so dass die Hauptabstrahlrichtung der Siebensegmentanzeige im wesentlichen der Hauptabstrahlrichtung der Sendevorrichtung entspricht. Die Siebensegmentanzeige kann beispielsweise dazu genutzt werden, Energieabgabestufen der Heizkörper, Temperaturen oder beispielsweise die Zeit anzuzeigen. Dadurch, dass die Anzeige zumindest teilweise von der Bestückungsseite des Trägers kommend in eine Ausnehmung im Träger ragt, kann der als Leiterplatte ausgebildete Träger weiterhin nur eine Bestückungsseite aufweisen. Als Anzeigevorrichtung kann jede Art der Anzeige verwendet werden, beispielsweise auch ein Display.

Diese und weitere Merkmale gehen außer aus den Ansprüchen auch aus der Beschreibung und den Zeichnungen hervor, wobei einzelne Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen könne, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen:
- Fig. 1: einen Ausschnitt eines Glaskeramikkochfeldes, unter dem ein Berührschalter und eine Anzeigevorrichtung angeordnet sind,
- Fig. 2: eine Schnittansicht entlang der Linie A-A des in Fig. 1 dargestellten Ausschnitts,
- Fig. 3: eine Detailansicht des unbetätigten Berührschalters gemäß Bezugszeichen C in Fig. 2,
- Fig. 4: eine Detailansicht des betätigten Berührschalters gemäß Bezugszeichen C in Fig. 2 und
- Fig. 5: eine Detailansicht verschiedener Berührschalter-Berührflächen gemäß Bezugszeichen B in Fig.1.

### Detaillierte Beschreibung der Zeichnungen

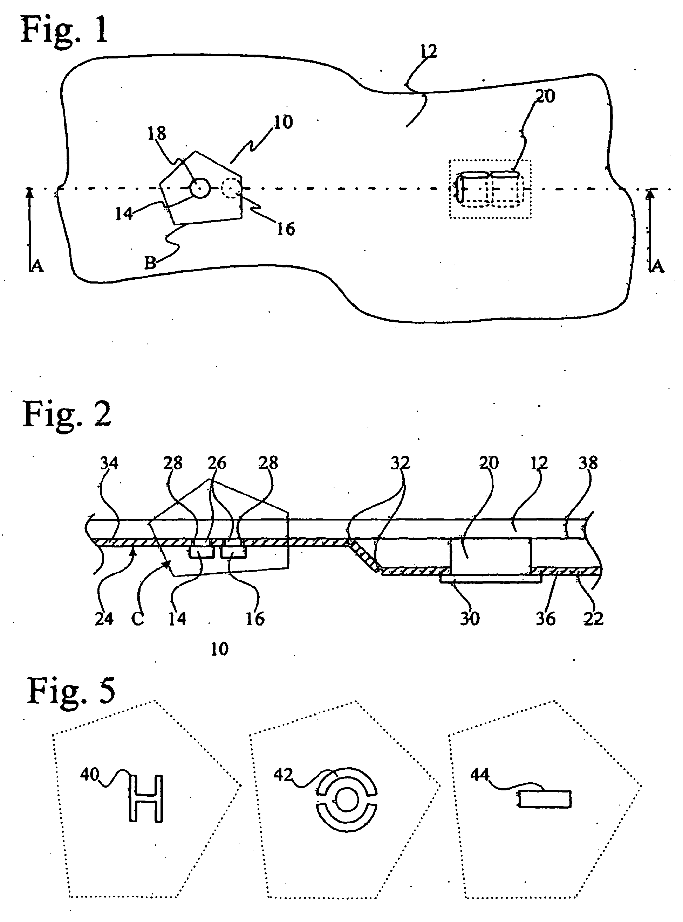

Fig. 1 zeigt einen erfindungsgemäßen optischen Berührschalter 10, der unter einem Glaskeramikkochfeld 12 angeordnet ist. Von dem optischen Berührschalter 10 ist der Lichtsender 14 und der Lichtempfänger 16 angedeutet zu erkennen. Diese sind einen Zwischenraum bildend angeordnet. Das vom Lichtsender 14 emittierte Licht kann, bei der Verwendung eines Lichtsenders, der Licht im sichtbaren Wellenlängen-Bereich emittiert, an der Oberfläche des Glaskeramikkochfeldes 12 als Lichtkreis 18 wahrgenommen werden. Vorzugsweise wird jedoch Licht mit einer nicht-sichtbaren Wellenlänge genommen.

Neben dem optischen Berührschalter 10 ist eine Siebensegmentanzeige 20 als Anzeigevorrichtung angeordnet. Sie kann beispielsweise zur Darstellung eines von einem Benutzer gewählten Energieabgabeniveaus eines nicht dargestellten Heizelementes Verwendung finden, das ebenfalls in dem Glaskeramikkochfeld 12 angeordnet ist.

In der Fig. 2 ist ebenfalls die Anordnung des optischen Berührschalters 10 mit dem Lichtsender 14 und dem Lichtempfänger 16 zu erkennen. Lichtsender 14 und Lichtempfänger 16 sind an einer Bestückungsseite 24 eines Bauteilträgers 22 angebracht, vorzugsweise an entsprechenden Leiterbahnen angelötet, der als Leiterplatte ausgebildet ist. Dabei sind in der Leiterplatte 22 Ausnehmungen 26 vorgesehen, die zum einen die Ausbreitung des vom Lichtsender 14 emittierten Lichtes beschränken und zum anderen den Bereich begrenzen, aus dem für den Lichtempfänger 16 wahrnehmbares Licht auf den Lichtempfänger 16 treffen kann. Die Flanken der Ausnehmungen 26 sind mit einer reflektierenden Schicht 28 überzogen, die aus jeder Art reflektierenden Materials bestehen kann.

Die Siebensegmentanzeige 20 ist von der Bestückungsseite 24 der Leiterplatte 22 kommend so durch eine weitere Ausnehmung in der Leiterplatte 22 hindurch gesteckt, dass ein Kragen 30, der Teil der Siebensegmentanzeige 20 ist, an der Bestückungsseite 24 der Leiterplatte anliegt. An dem Kragen 30 sind nicht dargestellte Kontakte zur Übertragung von elektrischen Signalen zur Siebensegmentanzeige vorgesehen.

In dieser Ausgestaltung der Erfindung ist zwischen dem Lichtsender 14 und dem Lichtempfänger 16 und der wenigstens einen Siebensegmentanzeige 20 ein Zwischenraum bzw. Abstand vorgesehen. Zum Ausgleich unterschiedlicher Höhenausdehnungen der Leiterplatte 22 und der Siebensegmentanzeige 20, die beide zumindest teilweise an der Unterseite des Glaskeramikkochfeldes 12 anliegen, sind in der Leiterplatte, wechselseitige Ausnehmungen und/oder Materialschwächungen ausgebildet. Vorzugsweise sind es wenigstens zwei Nuten 32 zum Abbiegen der Leiterplatte 22, die darin eingefräst sind. Durch die Möglichkeit des Ausgleichs unterschiedlicher Höhen von Leiterplatte 22 und Siebensegmentanzeige 20 kann die gesamte Elektronik auf einem Träger, insbesondere einer Leiterplatte, angeordnet sein, ohne dass zusätzliche Steckverbindungen oder Leitungen nötig sind.

Die Leiterplatte 22 ist also abgeknickt ausgeführt, so dass unterschiedliche Höhenausdehnungen der unterschiedlichen Bauteile ausgeglichen werden können. Die Seiten, an denen die Nuten 32 eingebracht sind, sind die Bestückungsseite 24 und die der Bestückungsseite 24 gegenüberliegenden Seite. Durch die Nuten 32 wird die Leiterplatte 22 derart geschwächt, dass sie verformt werden kann, ohne dass sie zerstört wird.

Der Versatz in der Leiterplatte, der sie in einen oberen Leiterplattenabschnitt 34 und einen unteren Leiterplattenabschnitt 36 unterteilt, ist in der hier beschriebenen erfindungsgemäßen Ausführung zwischen dem optischen Berührschalter 10 und der Siebensegmentanzeige 20 angeordnet. Dadurch kann sowohl die Siebensegmentanzeige 20, die die Leiterplatte 22 in der Höhenausdehnung deutlich überragt, als auch der obere Leiterplattenabschnitt 34, der nur an der Bestückungsseite 24 Bauteile aufweist, plan an der Unterseite 38 des Glaskeramikkochfeldes 12 liegen. So werden weitestgehend identische Hauptabstrahlrichtungen des Lichtsenders 14 und der Siebensegmentanzeige 20 erreicht.

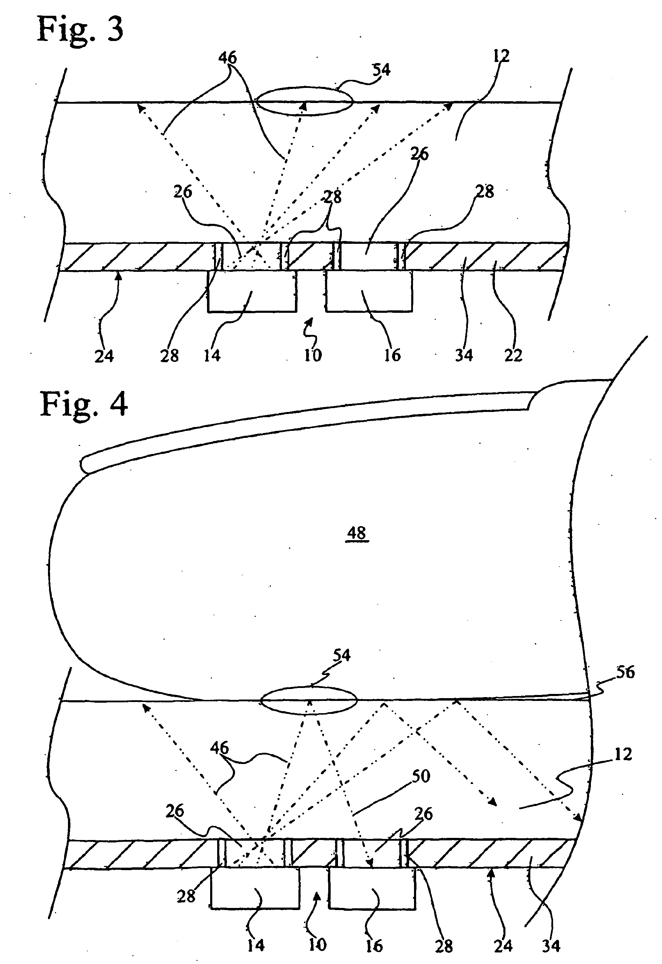

Fig. 3 zeigt den unbetätigten Zustand des Berührschalters 10. Die vom Lichtsender 14 emittierten Lichtstrahlen 46 treten teilweise ungehindert durch die Ausnehmung 26 in der Leiterplatte 22 hindurch. Lichtstrahlen, die schräg aus dem Lichtsender austreten, werden an der Reflektionsschicht 28 reflektiert, die die Flanke der Ausnehmung 26 bedeckt. Dadurch entsteht ein Bereich 54 im angestrahlten Bereich, auf den eine erhöhte Anzahl von Lichtstrahlen 46 trifft.

Damit die Lichtstrahlen 46 zum Lichtempfänger 16 gelangen, müssen sie an der Oberfläche 56 des Glaskeramikkochfeldes 12 reflektiert werden. Dies geschieht, wenn ein Bereich bzw. der Bereich 54 von einem Gegenstand, beispielsweise einem Finger 48, abgedeckt wird, insbesondere durch direktes Auflegen auf die Oberseite des Glaskeramikkochfeldes 12.

Wie der Fig. 4 zu entnehmen ist, wird das Licht 46 im Bereich 54 weitestgehend ungerichtet reflektiert. Beispielhaft ist dies durch das Lichtbündel 50 dargestellt, das entlang des Mittelstrahls 50 verläuft. Das Lichtbündel 50 tritt durch die Ausnehmung 26 in der Leiterplatte 22 und gelangt so über Reflexion an der Unterseite des Fingers im Bereich 54 zum Lichtempfänger 16. Um die Lichtmenge zu erhöhen, die den Lichtempfänger 16 erreicht, können Teile des reflektierten Lichtbündels 50 an der Reflektionsschicht 28 in Richtung des Lichtempfängers 16 reflektiert werden, was nicht dargestellt ist, jedoch offensichtlich ist. Der in den Fig. 3 und 4 ganz links dargestellte ausgesandte Lichtstrahl wird gar nicht oder nur kaum reflektiert, da in seinem Auftreffbereich auf das Glaskeramikkochfeld 12 der Finger 48 nicht aufgelegt ist. Trifft eine ausreichende Lichtmenge auf den Lichtempfänger 16, gibt dieser ein entsprechendes Signal an eine nicht dargestellte Steuerelektronik weiter.

Um ein versehentliches Schalten zu vermeiden, kann vorgesehen werden, dass erst nach Ablauf einer definierten Zeitspanne, in der reflektiertes Licht 50 auf den Lichtempfänger 16 trifft, ein Schaltvorgang ausgelöst wird. Weiterhin kann, um einen durch Tageslicht oder künstliches Licht ausgelösten ungewollten Schaltvorgang zu verhindern, der Lichtempfänger derart eingestellt sein, dass er nur auf Licht mit bestimmter Wellenlänge reagiert, das dann vom Lichtsender 14 emittiert wird und bevorzugt im nicht-sichtbaren Wellenlängen-Bereich liegt.

Liegen die Oberseiten von Lichtsender 14 und Lichtempfänger 16 nicht ganz an der Unterseite des Glaskeramikkochfeldes 12 an, so werden die Lichtstrahlen an den Übergängen etwas gebeugt bzw. abgelenkt. Dies ändert aber insbesondere aufgrund der geringen Abstände nichts an dem hier beschriebenen Grundprinzip.

Zwischen den Leiterplattenabschnitt 34 und die Unterseite 38 des Glaskeramikkochfeldes 12 kann eine Symbolschablone derart eingebracht werden, dass ein Symbol von oben zu sehen ist. In Fig. 5 sind beispielhafte Symbole 40, 42, 44 dargestellt. So kann ein Symbol H als Buchstabe 40, als Symbol für ein Heizelement 42, oder als ein mathematisches Symbol 44, wie beispielsweise ein Plus- oder Minus-Symbol, ausgeführt sein. Auch ist vorstellbar, dass das Symbol bei der Verwendung mehrerer Heizelemente die Position des Heizelementes darstellt, das mit dem optischen Berührschalter 10 betätigt wird.

## Patentansprüche

1. Optischer Berührschalter, insbesondere für ein zumindest teilweise lichtdurchlässiges Glaskeramikkochfeld (12), mit wenigstens einem Lichtsender (14) und wenigstens einem Lichtempfänger (16) an oder in wenigstens je einem oder einem gemeinsamen Träger (22), wobei das von dem Lichtsender (14) ausgehende Lichtsignal (46) und/oder das von dem Lichtempfänger zu empfangende Lichtsignal durch wenigstens einen maskenartigen Abschnitt des Trägers (22) mit wenigstens einer Ausnehmung (26) und/oder einem Trennsteg begrenzt ist, **dadurch gekennzeichnet, dass** der Träger (22) als Bauteilträger ausgebildet ist und eine Bestückungsseite (24) zur Aufnahme von Bauteilen aufweist, wobei der Träger (22) zumindest teilweise mit einer Seite, die der Bestückungsseite (24) gegenüberliegt, an einer Unterseite (38) einer Abdeckung (12) anliegt und wobei an der Bestückungsseite (24) Lichtsender (14) und/oder Lichtempfänger (16) vorgesehen sind.

2. Optischer Berührschalter nach Anspruch 1, **dadurch gekennzeichnet, dass** der Berührschalter (10) als Reflexionslichtschranke mit wenigstens je einem Lichtsender (14), vorzugsweise einer lichtemittierenden Diode, und einem Lichtempfänger (16), vorzugsweise einem Phototransistor, ausgebildet ist.

3. Optischer Berührschalter nach wenigstens einem der Ansprüche 1 oder 2, **dadurch gekennzeichnet, dass** der Träger (22) als Leiterplatte ausgebildet ist.

4. Optischer Berührschalter nach Anspruch 1 oder 3, **dadurch gekennzeichnet, dass** der Träger (22) vollständig mit der Seite, die der Bestückungsseite (24) gegenüberliegt, an der Unterseite (38) der Abdeckung (12) anliegt.

5. Optischer Berührschalter nach wenigstens einem der vorstehenden Ansprüche, **dadurch gekennzeichnet, dass** Lichtsender (14) und/oder Lichtempfänger (16) teilweise in der wenigstens einen Ausnehmung (26) im Träger befestigt (22) sind, vorzugsweise direkt an der Ausnehmung.

6. Optischer Berührschalter nach wenigstens einem der vorstehenden Ansprüche, **dadurch gekennzeichnet, dass** die Ausnehmungen (26) im Träger (22) an ihren Flanken reflektierend ausgebildet sind, insbesondere eine reflektierende Schicht (28) aufweisen.

7. Optischer Berührschalter nach wenigstens einem der vorstehenden Ansprüche, **dadurch gekennzeichnet, dass** der Träger (22) eine Dicke bis zu 5mm aufweist, vorzugsweise eine Dicke zwischen 1 mm und 2mm.

8. Optischer Berührschalter nach wenigstens einem der vorsehenden Ansprüche, **dadurch gekennzeichnet, dass** die maskenartige Ausnehmung (26) im Träger (22), vorzugsweise der Teil der maskenartigen Ausnehmung (26) über dem Lichtsender (14), als eine Anzeigevorrichtung, vorzugsweise als ein Symbol (40, 42, 44), ausgebildet ist.

## Claims

1. Optical touch switch, in particular for an at least partially translucent glass ceramic hob (12) with at least one light transmitter (14) and at least one light receiver (16) on or in at least one carrier (22) each or one common carrier, where the light signal (46) emitted by the light transmitter (14) and/or the light signal to be received by the light receiver is limited by at least one mask-like section of the carrier (22) with at least one recess (26) and/or one separating web, **characterized in that** the carrier (22) is designed as a component carrier and has an insertion side (24) for receiving components, where the carrier (22) is in contact by a side opposite the insertion side (24) at least partially with an underside (38) of a cover (12) and where light transmitters (14) and/or light receivers (16) are provided on the insertion side (24).

2. Optical touch switch according to Claim 1, **characterized in that** the touch switch (10) is designed as a reflection light barrier with at least one light transmitter (14) each, preferably a light-emitting diode, and one light receiver (16), preferably a phototransistor.

3. Optical touch switch according to at least one of Claims 1 or 2, **characterized in that** the carrier (22) is designed as a printed circuit board.

4. Optical touch switch according to Claim 1 or 3, **characterized in that** the carrier (22) is completely in contact by its side opposite the insertion side (24) with the underside (38) of the cover (12).

5. Optical touch switch according to at least one of the preceding claims, **characterized in that** light transmitters (14) and/or light receivers (16) are fastened partially in the at least one recess (26) in the carrier (22), preferably directly at the recess.

6. Optical touch switch according to at least one of the preceding claims, **characterized in that** the recesses (26) in the carrier (22) are designed reflecting on their flanks, and in particular have a reflecting layer (28).

7. Optical touch switch according to at least one of the preceding claims, **characterized in that** the carrier (22) has a thickness of up to 5 mm, preferably a thickness between 1 mm and 2 mm.

8. Optical touch switch according to at least one of the preceding claims, **characterized in that** the mask-like recess (26) in the carrier (22), preferably that part of the mask-like recess (26) above the light transmitter (14), is designed as a display device, preferably as a symbol (40, 42, 44).

## Revendications

1. Commutateur optique à touche tactile, en particulier pour une plaque vitrocéramique (12) au moins en partie transparente, avec au moins un émetteur de lumière (14) et au moins un récepteur de lumière (16) sur ou dans au moins respectivement un support ou un support commun (22), sachant que le signal lumineux (46) émis par l'émetteur de lumière (14) et/ou le signal lumineux devant être reçu par le récepteur de lumière est limité par au moins une section de type masquant du support (22) avec au moins un évidement (26) et/ou une nervure de séparation, **caractérisé en ce que** le support (22) est conçu sous forme de porte-éléments et présente un côté composants (24) pour le logement de composants, sachant que le support (22) est accolé au moins en partie avec un côté opposé au côté composants (24) contre un côté inférieur (38) d'un élément de recouvrement (12) et que des émetteurs de lumière (14) et/ou des récepteurs de lumière (16) sont prévus sur le côté composants (24).

2. Commutateur optique à touche tactile selon la revendication 1, **caractérisé en ce que** le commutateur à touche tactile (10) est conçu sous forme de barrière lumineuse à réflexion avec au moins respectivement un émetteur de lumière (14), de préférence une diode électroluminescente, et un récepteur de lumière (16), de préférence un phototransistor.

3. Commutateur optique à touche tactile selon au moins l'une des revendications 1 ou 2, **caractérisé en ce que** le support (22) est conçu sous forme de circuit imprimé.

4. Commutateur optique à touche tactile selon la revendication 1 ou 3, **caractérisé en ce que** le support (22) est accolé entièrement avec son côté opposé au côté composants (24) contre le côté inférieur (38) de l'élément de recouvrement (12).

5. Commutateur optique à touche tactile selon au moins l'une des revendications précédentes, **caractérisé en ce que** les émetteurs de lumière (14) et/ou les récepteurs de lumière (16) sont fixés en partie dans un évidement (26) au moins en présence dans le support (22), de préférence directement sur l'évidement.

6. Commutateur optique à touche tactile selon au moins l'une des revendications précédentes, **caractérisé en ce que** les évidements (26) dans le support (22) sont réfléchissants sur leurs flancs, et présentent en particulier une couche réfléchissante (28).

7. Commutateur optique à touche tactile selon au moins l'une des revendications précédentes, **caractérisé en ce que** le support (22) présente une épaisseur allant jusqu'à 5 mm, de préférence une épaisseur comprise entre 1 mm et 2 mm.

8. Commutateur optique à touche tactile selon au moins l'une des revendications précédentes, **caractérisé en ce que** l'évidement de type masquant (26) dans le support (22), de préférence la partie de l'évidement de type masquant (26) au-dessus de l'émetteur de lumière (14), est conçu sous forme d'un dispositif d'affichage, de préférence sous forme d'un symbole (40, 42, 44).
